(19) Europäisches Patentamt
European Patent Office
Office européen des brevets

(11) Veröffentlichungsnummer : **0 498 766 A2**

(12) # EUROPÄISCHE PATENTANMELDUNG

(21) Anmeldenummer : **92810058.5**

(22) Anmeldetag : **27.01.92**

(51) Int. Cl.$^5$ : **C08L 71/12,** B32B 27/28, // (C08L71/12, 63:00)

(30) Priorität : **04.02.91 CH 328/91**

(43) Veröffentlichungstag der Anmeldung : **12.08.92 Patentblatt 92/33**

(84) Benannte Vertragsstaaten : **BE CH DE FR GB IT LI NL**

(71) Anmelder : **CIBA-GEIGY AG**
**Klybeckstrasse 141**
**CH-4002 Basel (CH)**

(72) Erfinder : **Pfaendner, Rudolf, Dr.**
**Sackgasse 3**
**W-6149 Rimbach/Odenwald 1 (DE)**
Erfinder : **Scharf, Wolfgang, Dr.**
**Röttler Ring 11c**
**W-7889 Grenzach-Wyhlen (DE)**
Erfinder : **Kainmüller, Thomas, Dr.**
**Am Kümmelberg 1**
**W-6145 Lindenfels 1 (DE)**
Erfinder : **Haug, Theobald, Dr.**
**Untere Flühackerstrasse 12**
**W-4402 Frenkendorf (CH)**

(54) **Modifizierte Polyarylenether.**

(57) Zusammensetzungen enthaltend
a) 2-40 Gew.% eines mehrfunktionellen Epoxids mit mindestens zwei direkt an ein Sauerstoff-, Stickstoff- oder Schwefelatom gebundenen Glycidylgruppen und
b) 98-60 Gew.% eines vorwiegend OH-terminierten Homo- oder Copolymers mit einem Hydroxylgruppengehalt von mindestens 10 $\mu$val/g, welches 1-100 mol% eines wiederkehrenden Strukturelements der Formel (I)

$$\left[ O - Ar_2 - O - Ar_1 \right] \quad (I)$$

und 99-0 mol% eines wiederkehrenden Strukturelements der Formel (II)

$$\left[ O - Ar_3 - O - Ar_1 \right] \quad (II),$$

enthält, worin $Ar_1$, $Ar_2$ und $Ar_3$ zweiwertige aromatische Reste darstellen, eignen sich zur Herstellung von lösungsmittelbeständigen Beschichtungen oder Verklebungen, insbesondere zur Herstellung von flexiblen Laminaten.

EP 0 498 766 A2

Die vorliegende Erfindung betrifft Polyarylenether/Epoxid-Zusammensetzungen sowie daraus hergestellte flexible Laminate.

Polyarylenether sind Werkstoffe mit sehr guten mechanischen und thermischen Eigenschaften, die, wie beispielsweise in der EP-A 89 387 beschrieben, zur Herstellung von flexiblen Laminaten verwendet werden können. Flexible Laminate müssen neben guten thermischen und elektrischen Eigenschaften eine gute Chemikalienbeständigkeit und vor allem eine hohe Flexibilität aufweisen, d.h. diese Verbundmaterialien sollten sehr oft gefaltet werden können, bevor es zu einem Bruch kommt. Eine weitere wichtige Eigenschaft ist eine hohe Haftung zwischen dem Polymerfilm und der Metallfolie auch bei hohen Temperaturen. Die Haftung von Polyarylenethern auf Metall ist jedoch vielfach unbefriedigend. So werden beispielsweise in den JP-A 62/242530, 62/18430, 62/242529 und 54/129077 Polyarylenethersulfon-Laminate beschrieben, die deshalb mittels einer Klebstoffschicht aufgebracht werden. Klebstoff-Zwischenschichten verlieren jedoch ihre gute Haftung bei erhöhten Temperaturen. Als eine weitere Massnahme zum Erzielen einer hohen Haftung wird in der EP-A 315 851 die Verwendung einer Metallfolie mit vergrösserter Oberfläche vorgeschlagen. Die dort beschhriebene oxidierte Kupferfolie führt zwar zu einer verbesserten Haftung, die jedoch noch nicht für alle Belange ausreichend ist.
Ausserdem wird die Chemikalienbeständigkeit durch die beschriebenen Massnahmen nicht verbessert.

Es wurden nun Laminate auf Basis von Polyarylenether/Epoxid-Zusammensetzungen entwickelt, die sich durch hohe Chemikalienbeständigkeit, gute flexible Eigenschaften und eine besonders hohe Haftung auszeichnen.

Gegenstand der vorliegenden Erfindung sind Zusammensetzungen enthaltend

a) 2-40 Gew.% eines mehrfunktionellen Epoxids mit mindestens zwei direkt an ein Sauerstoff-, Stickstoff- oder Schwefelatom gebundenen Glycidylgruppen und

b) 98-60 Gew.% eines vorwiegend OH-terminierten Homo- oder Copolymers mit einem Hydroxylgruppengehalt von mindestens 10 µval/g, welches 1-100 mol% eines wiederkehrenden Strukturelements der Formel (I)

$$\left[ O - Ar_2 - O - Ar_1 \right] \quad (I)$$

und 99-0 mol% eines wiederkehrenden Strukturelements der Formel (II)

$$\left[ O - Ar_3 - O - Ar_1 \right] \quad (II),$$

enthält,

worin $Ar_1$ einen zweiwertigen aromatischen Rest der Formeln (IIIa) - (IIIe) darstellt

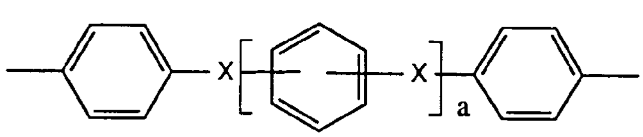
(IIIa),

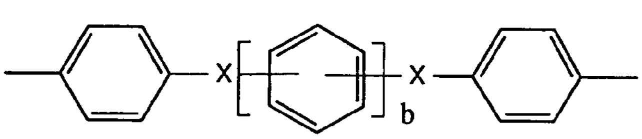
(IIIb),

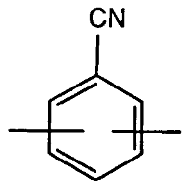 (IIIc), 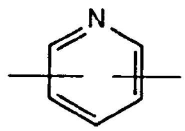 (IIId), 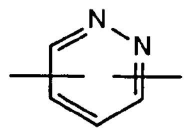 (IIIe),

worin X für -CO-, -SO- oder $-SO_2-$ steht, a die Zahl 0, 1 oder 2 bedeutet und b die Zahl 2 oder 3 ist, $Ar_2$ einen zweiwertigen aromatischen Rest der Formeln (IVa) bis (IVp) bedeutet

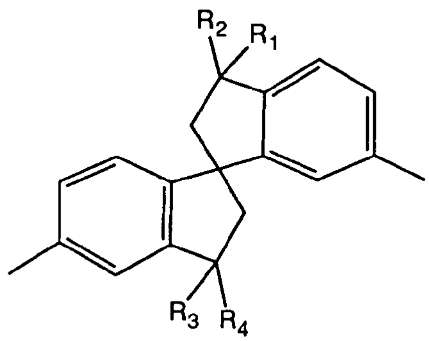 (IVa),

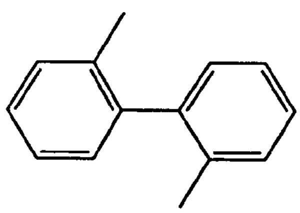 (IVb), 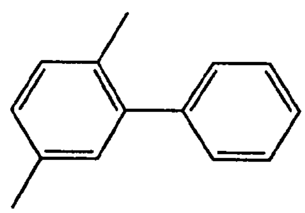 (IVc),

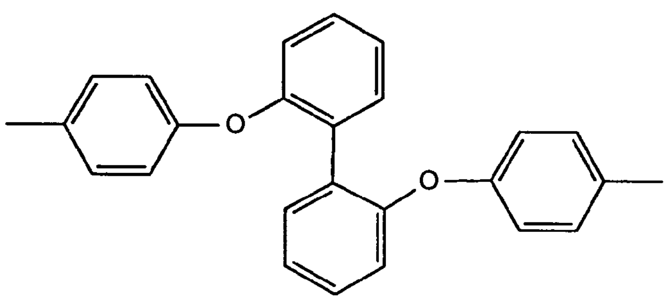 (IVd),

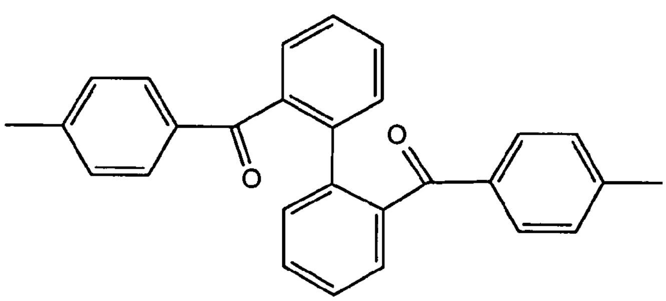 (IVe),

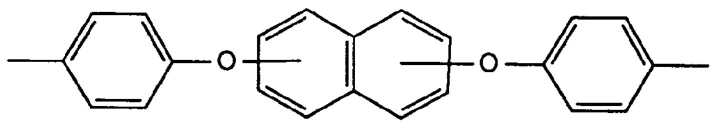 (IVf),

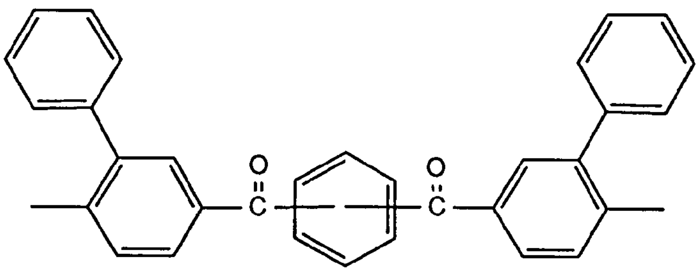 (IVg),

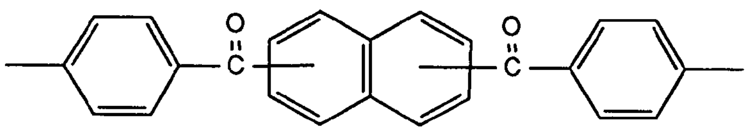 (IVh),

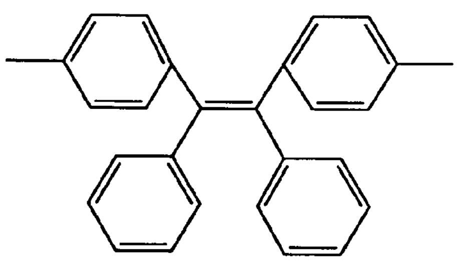 (IVi), 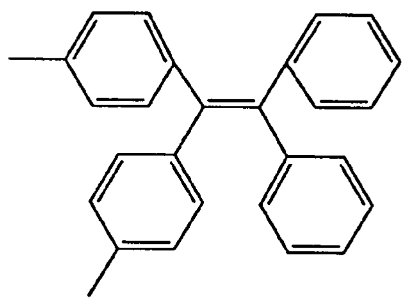 (IVj),

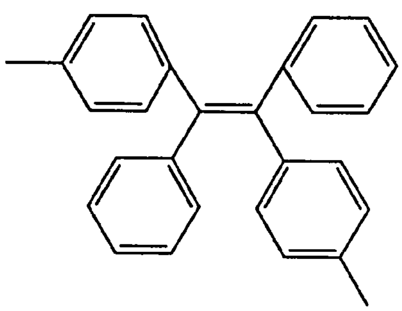 (IVk), 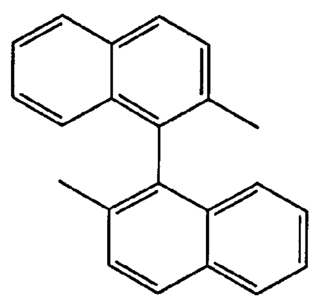 (IVl),

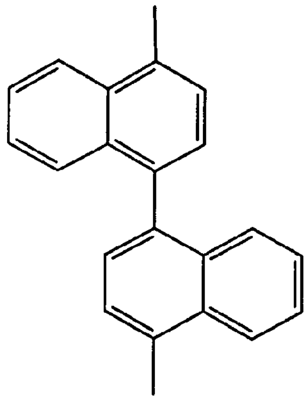 (IVm), 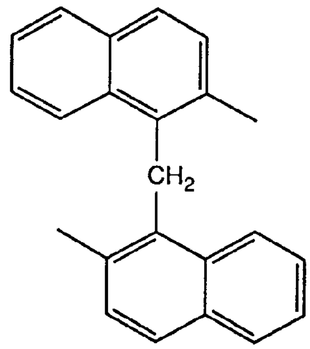 (IVn),

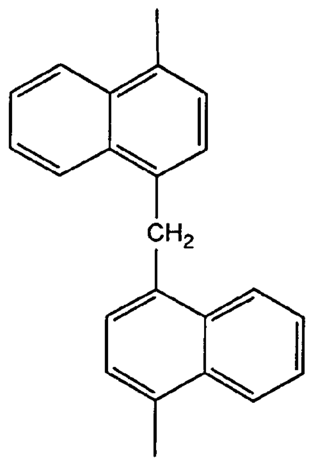 (IVo), 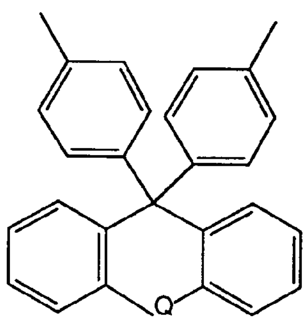 (IVp),

worin Q für eine direkte Bindung, $-CH_2-$, -O- oder -CO- steht,
$Ar_3$ einen zweiwertigen aromatischen Rest der Formeln (Va) bis (Vf) bedeutet

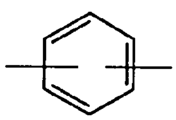 (Va), 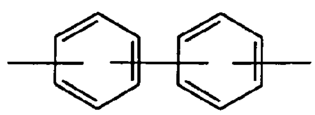 (Vb), 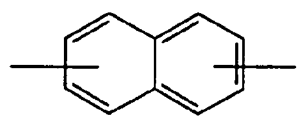 (Vc),

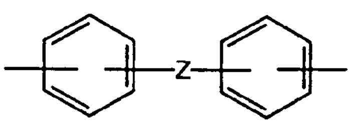 (Vd), 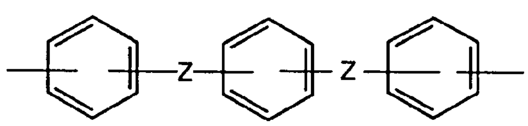 (Ve),

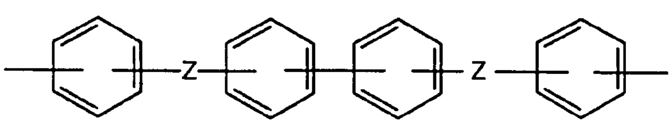 (Vf),

worin Z für $-CH_2-$, $-C(CH_3)_2-$, $-C(CH_3)(C_6H_5)-$, $-C(CF_3)_2-$, -S-, -O-, -SO-, $-SO_2-$ oder -CO- steht,
worin die aromatischen Ringe der Formeln (IIIa)-(IIIe) unsubstituiert oder durch eine oder mehrere $(C_1-C_4)$-Alkylgruppen oder $(C_1-C_4)$-Alkoxygruppen substituiert sind und worin die aromatischen Ringe der Formeln (IVa)-(IVp) und (Va)-(Vf) unsubstituiert oder durch eine oder mehrere $(C_1-C_4)$-Alkylgruppen, $(C_1-C_4)$-Al-

koxygruppen und/oder Halogenatome substituiert sind,
wobei die Menge des Epoxids a) so gewählt wird, dass pro Hydroxylgruppenäquivalent der Komponente b) 2-15 Epoxidäquivalente der Komponente a) eingesetzt werden.

$Ar_1$ in den Formeln (I) und II steht vorzugsweise für

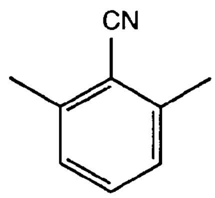

,

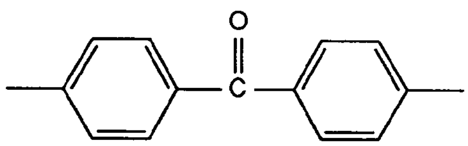

oder insbesondere für

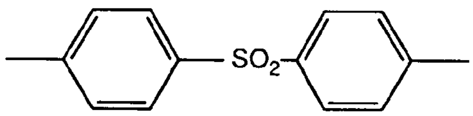

.

$Ar_2$ in der Formel (I) steht bevorzugt für

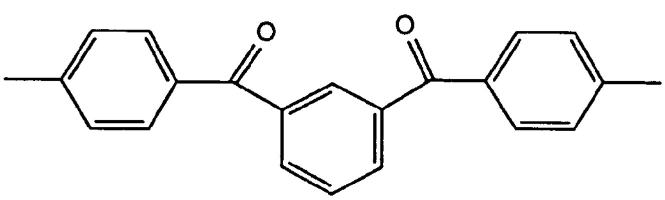

,

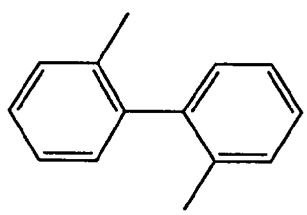

oder insbesondere für

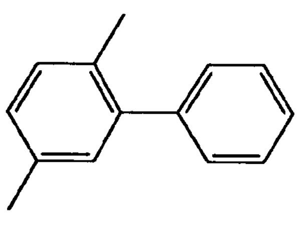

.

Die bevorzugte Bedeutung von $Ar_3$ in der Formel (II) ist ein Rest der Formeln

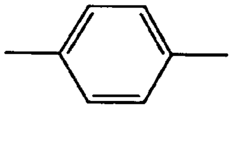

,

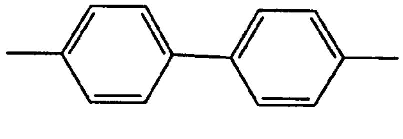

,

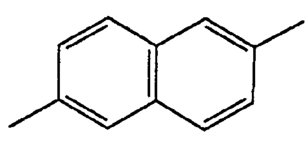

,

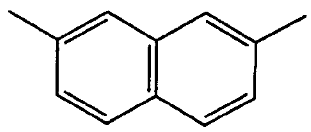 , 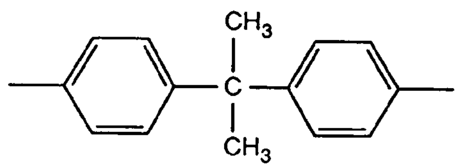 ,

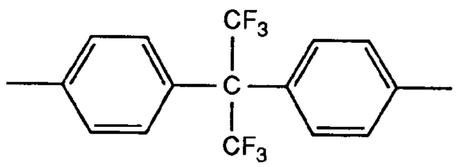 , 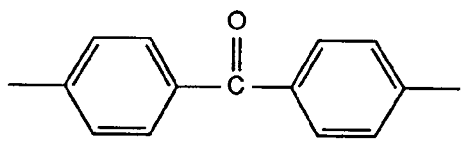

oder

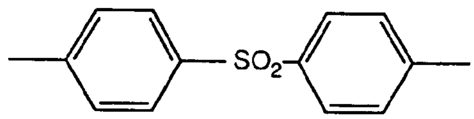 .

Besonders bevorzugt steht $Ar_3$ für

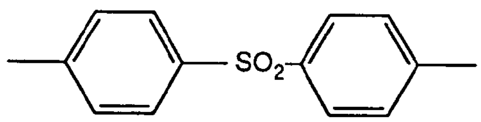 .

In besonders bevorzugten Komponenten b) stehen $Ar_1$ und $Ar_3$ für einen Rest der Formel

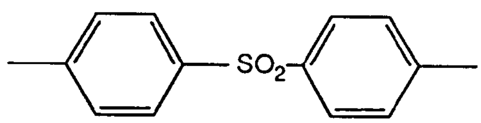 ,

und $Ar_2$ steht für einen Rest der Formel

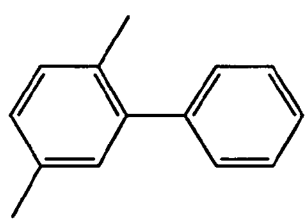 .

Sind die aromatischen Ringe der Strukturelemente (IIIa)-(IIIe), (IVa)-(IVp) und (Va)-(Vf) durch ($C_1$-$C_4$)-Alkylgruppen oder ($C_1$-$C_4$)-Alkoxygruppen substituiert, so handelt es sich dabei um verzweigte oder insbesondere um geradkettige Reste.

Beispiele für solche Alkylgruppen sind Methyl, Ethyl, n-Propyl, Isopropyl, n-Butyl, sek.-Butyl oder tert.-Butyl.

Beispiele für Alkoxygruppen sind Methoxy, Ethoxy, n-Propoxy, Isopropoxy, n-Butoxy oder tert.-Butoxy.

Sind die Reste der Formel (IVa)-(IVp) oder (Va)-(Vf) durch Halogenatome substituiert, so handelt es sich dabei um Fluor, Iod oder insbesondere um Chlor oder Brom.

Die aromatischen Ringe der Strukturelemente (IIIa)-(IIIe), (IVa)-(IVp) und (Va)-(Vf) sind vorzugsweise unsubstituiert.

Die vorwiegend OH-terminierten Homo- oder Copolymere enthaltend wiederkehrende Struktureinheiten der oben definierten Formeln (I) und (II) können nach an sich bekannten Methoden hergestellt werden, beispielsweise indem man, wie z.B. in der EP-A 388 358 beschrieben, eine Dihalogenverbindung der Formel (VI)

$$Hal\text{-}Ar_1\text{-}Hal \qquad (VI),$$

worin Hal für Halogen, insbesondere Fluor oder Chlor steht und $Ar_1$ die oben angegebene Bedeutung hat, mit einer Dihydroxyverbindung der Formel (VII)

$$HO\text{-}Ar_2\text{-}OH \qquad (VII),$$

worin $Ar_2$ die oben angegebene Bedeutung hat, allein oder mit einem Gemisch aus einer Verbindung der Formel (VII) und einer darin bis zu 99 mol% enthaltenen Dihydroxyverbindung der Formel (VIII),

$$HO\text{-}Ar_3\text{-}OH \qquad (VIII),$$

worin $Ar_3$ die oben angegebene Bedeutung hat, in an sich bekannter Weise in Gegenwart alkalischer Katalysatoren in einem polaren aprotischen Lösungsmittel polykondensiert.

In den erfindungsgemässen Zusammensetzungen kann als mehrfunktionelles Epoxid im Prinzip jede in der Technik der Epoxidharze übliche Verbindung eingesetzt werden.

Beispiele für Epoxide sind:

I) Polyglycidyl- und Poly(ß-methylglycidyl)ester erhältlich durch Umsetzung einer Verbindung mit mindestens zwei Carboxylgruppen im Molekül und Epichlorhydrin bzw ß-Methylepichlorhydrin. Die Umsetzung erfolgt zweckmässig in Gegenwart von Basen.

Als Verbindung mit mindestens zwei Carboxylgruppen im Molekül können aliphatische Polycarbonsäuren verwendet werden. Beispiele für diese Polycarbonsäuren sind Oxalsäure, Bernsteinsäure, Glutarsäure, Adipinsäure, Pimelinsäure, Korksäure, Azelainsäure oder dimerisierte bzw. trimerisierte Linolsäure.

Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.

Weiterhin können aromatische Polycarbonsäuren Verwendung finden, wie beispielsweise Phthalsäure, Isophthalsäure oder Terephthalsäure.

II) Polyglycidyl- oder Poly(ß-methylglycidyl)ether erhältlich durch Umsetzung einer Verbindung mit mindestens zwei freien alkoholischen Hydroxygruppen und/oder phenolischen Hydroxygruppen und Epichlorhydrin oder ß-Methylepichlorhydrin unter alkalischen Bedingungen, oder in Anwesenheit eines sauren Katalysators und anschliessende Alkalibehandlung.

Ether dieses Typs leiten sich beispielsweise ab von acyclischen Alkoholen, wie Ethylenglykol, Diethylenglykol und höheren Poly(oxyethylen)glykolen, Propan-1,2-diol oder Poly(oxypropylen)glykolen, Propan-1,3-diol, Butan-1,4-diol, Poly(oxytetramethylen)glykolen, Pentan-1,5-diol, Hexan-1,6-diol, Hexan-2,4,6-triol, Glycerin, 1,1,1-Trimethylolpropan, Pentaerythrit, Sorbit, sowie von Polyepichlorhydrinen.

Sie leiten sich aber auch beispielsweise ab von cycloaliphatischen Alkoholen, wie 1,4-Cyclohexandimethanol, Bis(4-hydroxycyclohexyl)methan oder 2,2-Bis(4-hydroxycyclohexyl)propan, oder sie besitzen aromatische Kerne, wie N,N-Bis(2-hydroxyethyl)anilin oder p,p′-Bis(2-hydroxyethylamino)diphenylmethan.

Die Epoxidverbindungen können sich auch von einkerningen Phenolen ableiten, wie beispielsweise von Resorcin oder Hydrochinon; oder sie basieren auf mehrkernigen Phenolen, wie beispielsweise Bis(4-hydroxyphenyl)methan, 4,4′-Dihydroxybiphenyl, Bis(4-hydroxyphenyl)sulon, 1,1,2,2-Tetrakis(4-hydroxyphenyl)ethan, 2,2-Bis(4-hydroxyphenyl)propan oder 2,2-Bis(3,5-dibrom-4-hydroxyphenyl)propan, oder auf Novolaken erhältlich durch Kondensation von Aldehyden, wie Formaldehyd, Acetaldehyd, Chloral oder Furfuraldehyd, mit Phenolen, wie Phenol, oder mit Phenolen, die im Kern mit Chloratomen oder $C_1$-$C_9$-Alkylgruppen substituiert sind, wie beispielsweise 4-Chlorphenol, 2-Methylphenol oder 4-tert-Butylphenol, oder durch Kondensation mit Bisphenolen, so wie oben beschrieben.

III) Poly(N-glycidyl)verbindungen erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um Anilin, n-Butylamin, Bis(4-aminophenyl)methan, m-Xylylendiamin oder Bis(4-methylaminophenyl)methan.

Zu den Poly(N-glycidyl)verbindungen zählen aber auch Triglycidylisocyanurat, N,N′-Diglycidylderivate von Cycloalkylenharnstoffen, wie Ethylenharnstoff oder 1,3-Propylenharnstoff, und Diglycidylderivate von Hydantoinen, wie von 5,5-Dimethylhydantoin.

IV) Poly(S-glycidyl)verbindungen, beispielsweise Di-S-glycidylderivate, die sich von Dithiolen, wie beispielsweise Ethan-1,2-dithiol oder Bis(4-mercaptomethylphenyl)ether, ableiten.

V) Cycloaliphatische Epoxide, beispielsweise Bis(2,3-epoxycyclopentyl)ether, 2,3-Epoxycyclopentylglycidylether, 1,2-Bis(2,3-epoxycyclopentyloxy)ethan oder 3,4-Epoxycyclohexylmethyl-3',4'-epoxycyclohexancarboxylat.

Es lassen sich aber auch Epoxide verwenden, bei denen die 1,2-Epoxidgruppen an unterschiedliche Heteroatome bzw. funktionelle Gruppen gebunden sind; zu diesen Verbindungen zählen beispielsweise das N,N,O-Triglycidylderivat des 4-Aminophenols, der Glycidylether-glycidylester der Salicylsäure, N-Glycidyl-N'-(2-glycidyloxypropyl)-5,5-dimethylhydantoin oder 2-Glycidyloxy-1,3-bis(5,5-dimethyl-1-glycidylhydantoin-3-yl)propan.

Die verwendeten Epoxide können auch durch Alkyl-, Alkenyl-, Alkoxy-, Aryl- oder Aryloxygruppen oder Halogenatome substituiert sein. Ein bevorzugtes Beispiel dafür ist o,o'-Diallylbisphenol-A-diglycidylether.

Bevorzugte Epoxide sind Bisphenol-A-diglycidylether, Bisphenol-F-diglycidylether, Bisphenol-S-diglycidylether, Resorcindiglycidylether, N,N,O-Triglycidyl-p-aminophenol, N,N,O-Triglycidyl-m-aminophenol, Triglycidylisocyanurat, Tetraglycidyl-4,4'-diaminodiphenylmethan und Tetra(p-glycidyloxyphenyl)ethan.

Bisphenol-A-diglycidylether ist besonders bevorzugt.

Die erfindungsgemässen Zusammensetzungen enthalten vorzugsweise 4-20 Gew. %, insbesondere 5-15 Gew.%, der Komponente a) und 96-80 Gew.%, insbesondere 95-15 Gew.%, der Komponente b).

Bei bifunktionellen Epoxiden wird bevorzugt ein Verhältnis Polyarylenether : Epoxid gewählt, das einen hohen Epoxidanteil aufweist; bei tri- und tetrafunktionellen Epoxiden wird bevorzugt ein Verhältnis gewählt, das einen niedrigen Epoxidanteil aufweist.

Das zu wählende Verhältnis ist ferner vom Molekulargewicht und der Zahl der OH-Endgruppen des eingesetzten Polyarylenethers abhängig. Bei einem Polyarylenether mit niedrigem Molekulargewicht und einer hohen Zahl funktioneller Endgruppen wird bevorzugt ein Verhältnis gewählt, das einen hohen Epoxidanteil aufweist. Bei einem Polyarylenether mit hohem Molekulargewicht wird ein Verhältnis gewählt, das einen niedrigen Epoxidanteil aufweist.

Gewünschtenfalls kann auch ein Gemisch von Polyarylenethern unterschiedlicher Struktur und/oder ein Gemisch von verschiedenen Epoxiden eingesetzt werden.

Die erfindungsgemässen Polyarylenether sind in vielen organischen Lösungsmitteln gut löslich und weisen für eine hohe thermische Stabilität (hohe Glasübergangstemperatur) bevorzugt einen hohen Gehalt an $SO_2$-Gruppen auf.

Bevorzugte Polyarylenether enthalten 5-50 mol%, insbesondere 5-25 mol%, wiederkelirende Struktureinheiten der Formel (I) und 95-50 mol%, insbesondere 95-75 mol%, Struktureinheiten der Formel (II).

Vorzugsweise weisen die Polyarylenether b) der erfindungsgemässen Zusammensetzungen einen Hydroxylgruppengehalt von mindestens 20 μval/g auf.

Aufgrund der guten Löslichkeit der erfindungsgemässen Zusammensetzungen in polaren aprotischen Lösungsmitteln wie N-Methylpyrrolidon, γ-Butyrolacton, N,N-Dimethylacetamid oder Dimethylsulfoxid und insbesondere auch in chlorierten Kohlenwasserstoffen wie Methylenchlorid oder 1,2-Dichlorethan oder auch in zyklischen Ketonen wie Cyclohexanon oder Cyclopentanon lassen sich die Gemische vorteilhaft aus einer Lösung heraus zur Herstellung von Beschichtungen auf Substraten aller Art verwenden oder auch zu Filmen verarbeiten.

Einen weiteren Erfindungsgegenstand bilden daher Lösungen enthaltend etwa 1-75 Gew.%, bezogen auf die gesamte Lösung, einer Zusammensetzung enthaltend die Komponenten a) und b), wie oben definiert.

Gegenstand der vorliegenden Erfindung sind auch Filme enthaltend eine Zusammensetzung auf der Basis der Komponenten a) und b), wie oben definiert

Als Substrate, die mit den erfindungsgemässen Zusammensetzungen beschichtet werden können, seien erwähnt:

Metalle oder Legierungen, wie Kupfer, Messing, Aluminium, Eisen oder Stahl, Asbest- oder Glasfasermaterialien, Polymere wie Cellulosematerialien (Celluloseester oder -ether, Papier), Polyester, Polyamide, Polyimide oder Polyurethane.

Nach Applikation und Trocknen erhält man eine Beschichtung mit verbesserter Lösungsmittelbeständigkeit, die sich durch eine sehr gute Haftung auf Metallen auszeichnet.

Der Trocknungsvorgang wird im allgemeinen bei erhöhter Temperatur, die je nach Art des verwendeten Lösungsmittels zwischen ca. 120 °C und ca. 260 °C betragen kann, und gegebenenfalls unter IR-Bestrahlung durchgeführt.

Die Dicke der Beschichtung kann je nach Anwendung in weiten Bereichen variieren; zweckmässig beträgt sie zwischen 5 μm und 200 μm, bevorzugt ist eine Beschichtungsdicke von 10-100 μm.

Es wurde ferner gefunden, dass mit den erfindungsgemässen Gemischen beschichtete Metallfolien ohne Verwendung zusätzlicher Verklebungshilfen, wie beispielsweise Acrylatkleber, direkt zu mehrschichtigen Laminaten verklebt werden können.

Gegenstand vorliegender Erfindung sind somit auch Laminate enthaltend mindestens eine Metallfolie und mindestens eine darauf direkt aufgebrachte Kunststoffschicht, die eine Zusammensetzung aus den Komponenten a) und b), wie oben definiert, enthält.

Als Metallfolie können die erfindungsgemässen Laminate beispielsweise solche aus Kupfer, Messing, Aluminium, Eisen oder Stahl enthalten. Vorzugsweise werden Kupferfolien verwendet.

Die Herstellung der erfindungsgemässen Laminate aus mit Polyarylenether/Epoxid-Zusammensetzungen beschichteten Metallfolien erfolgt nach bekannten Verfahren, z.B. durch Verpressen mit einer ebenso hergestellten beschichteten Metallfolie oder mit einer unbeschichteten Metallfolie unter Druck, beispielsweise 1-24 MPa, zwischen 160 °C und 300 °C.

Vorzugsweise werden dabei zwei einseitig mit einer Polyarylenether/Epoxid-Zusammensetzung beschichtete Metallfolien mit der beschichteten Seite zueinander unter Druck zwischen 160 und 300 °C verpresst. Die Temperatur richtet sich dabei nach der Glasübergangstemperatur des Polyarylenethers, der Epoxidmenge und der thermischen Stabilität des verwendeten Epoxids.

Die auf diese Weise hergestellten Laminate sind Materialien, die die guten mechanischen Eigenschaften der Polyethersulfone bei verbesserter Lösungsmittelbeständigkeit und sehr hohe Haftfestigkeiten aufweisen. Eine bevorzugte Anwendung der erfindungsgemässen Laminate, die sehr flexibel sind und mehrmals ohne Bruch gefaltet werden können, ist die Herstellung von elektronischen Schaltungen.

Für die Formulierungen in den nachfolgenden Beispielen 1 und 2 und im Vergleichsbeispiel A wird ein Polyethersulfon eingesetzt,das gemäss EP-A 388 358 synthetisiert wird und die folgende Struktur aufweist:

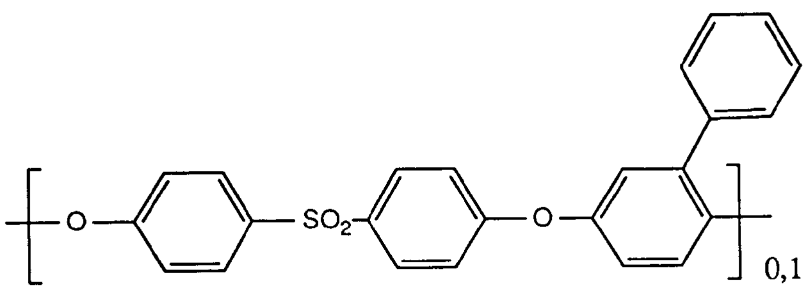

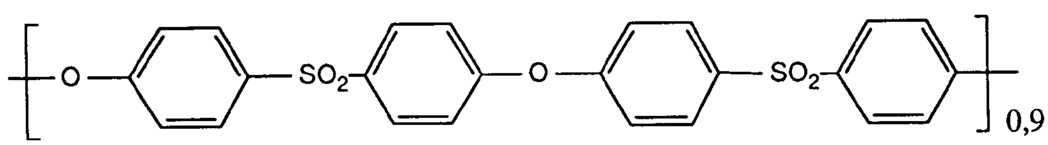

| | |
|---|---|
| reduzierte Viskosität (1 g in 100 ml NMP): | 0,61 dl/g |
| OH-Gruppen-Gehalt: | 55 µval/g |

Als Epoxid wird in den Beispielen ein Bisphenol-A-diglycidylether mit einem Epoxidgehalt von 5,26-5,38 val/kg eingesetzt.

Beispiel 1:

25,00 g Polyethersulfon,
1,25 g Epoxid,
148,75 g Methylenchlorid;

Vergleichsbeispiel A:

15,00 g Polyethersulfon,
85,00 g Methylenchlorid;

Zur Bestimmung der Kupferhaftung wird eine Kupferfolie mit einem Nassfilm von 200 µm der o.a. Zusammensetzungen auf der Behandlungsseite beschichtet. Nach einer Abdunstzeit von 1-2 min bei Raumtemperatur wird die Kupferfolie in einen Umluftofen von 60 °C gelegt und 30 min bei dieser Temperatur gehalten. Die Temperatur wird auf 120 °C gesteigert, und die Probe wird bei dieser Temperatur 30 min getrocknet.

Zwei solcherart getrocknete Kupferfolien werden mit der Beschichtung zueinanderliegend in eine 260 °C

heisse Presse eingefahren. Nach einer Kontaktzeit wird der Druck auf 4-5 MPa erhöht. Nach einer Presszeit von 15 min wird unter Druck auf eine Temperatur unter 150 °C abgekühlt, und das Laminat wird anschliessend entnommen. Nach Herausätzen der Probestreifen wird die Kupferhaftung ermittelt.

Zur Ermittlung der Flexibilität wird nach der gleichen Vorschrift gearbeitet, nur dass anstelle der zweiten beschichteten Kupferfolie eine Kupferfolie mit Trennschicht auf der Glanzseite verwendet wird.
"Flex-life" = Zahl der Faltungen bis zum Bruch des Laminats, bestimmt mittels Universal-Model 2 FDF Flex Ductility Tester mit Zuggewicht 224 g und 2 mm Dorn.

Die Kupferhaftungen und die Flexibilitätswerte der verschiedenen Zusammensetzungen sind in Tabelle 1 angegeben.

Tabelle 1:

| Beispiel | 1 | A |
|---|---|---|
| Kupferhaftung (N/cm) | | |
| bei Raumtemperatur | 24 | 10 - 11 |
| bei 150 °C | 24 - 26 | 7 - 8 |
| bei 260 °C | 4 - 5 | - |
| Flex-life (Zyklen) (Mittelwert aus 4 Messungen) | 288 | 277 |
| Materialdicke (µm) | 70 | 60 - 65 |

Aus den Werten der Tabelle 1 ist ersichtlich, dass das erfindungsgemässe Laminat gemäss Beispiel 1 eine wesentlich bessere Haftung und eine bessere Flexibilität als das Vergleichslaminat A aufweist.

Die gute Lösungsmittelbeständigkeit der erfindungsgemässen Laminate zeigt das folgende Beispiel 2.

Beispiel 2:

Auf eine Kupferfolie wird eine lösung, enthaltend 23,75 g Polyethersulfon 1,25 g Epoxid und 75 g N-Methylpyrrolidon, mittels einer Lackhantel (200 µm) aufgetragen und im Umluft-Lacktrockenschrank unter IR-Bestrahlung getrocknet (Umluft-Temperatur: 180 °C, 45 min, IR-Lampe: Heraeus Modell MMs 1200). Die Polymerschicht eines unter diesen Bedingungen hergestellten Laminates (Flex-life: 315, Mittelwert aus 5 Messungen) weist nach einstündigem Eintauchen in Methylenchlorid einen Gewichtsverlust von 3,3 % auf.

Beispiel 3:

Gemäss der Synthesevorschrift der Beispiele 7-18 der EP-A 404724 wird ein Polyethersulfon aus 0,0201 mol 2,2'-Dihydroxybiphenyl, 0,0201 mol Hexafluorbisphenol A, 0,3612 mol 4,4'-Dihydroxydiphenylsulfon, 0,4000 mol Dichlordiphenylsulfon und 0,4200 mol Kaliumcarbonat hergestellt (Reaktionsbedingungen: 1 h/250 °C, 1 h/275 °C, 2,5 h/280 °C). Das Reaktionsgemisch wird zunächst mit verdünnter Essigsäure und anschliessend mit Wasser/Aceton (1:4) extrahiert. Das Polymere wird in Methylenchlorid gelöst, filtriert und durch Eingiessen in Isopropanol ausgefällt. Das so erhaltene Polyethersulfon weist eine reduzierte Viskosität von 0,58 dl/g und einen OH-Gruppen-Gehalt von 27 µval/g auf. 95 Gewichtsteile dieses Polyethersulfons werden mit 5 Gewichtsteilen eines Bisphenol-A-diglycidylethers mit einem Epoxidgehalt von 5,26-5,38 val/kg in 400 Gewichtsteilen N-Methylpyrrolidon gelöst. Diese Lösung wird mit einer Schichtdicke von 200 µm auf eine Kupferfolie (Stärke 35 µm, NT-TW der Fa. Circuit Foils) aufgetragen und anschliessend 30 min bei 170 °C und 60 min bei 240 °C im Umlufttrockenschrank getrocknet. Die Eigenschaftswerte des Laminats sind in Tabelle 2 angegeben.

Beispiel 4:

Gemäss der Synthesevorschrift des Beispiels 9 der EP-A 456608 wird ein Polyethersulfon aus 0,0200 mol 4,4′-Dihydroxy-3,3′-diphenylisophthalophenon, 0,0200 mol 4,4′-Dihydroxybenzophenon, 0, 1600 mol 4,4′-Dihydroxydiphenylsulfon, 0,2001 mol Dichlordiphenylsulfon und 0,2205 mol Kaliumcarbonat hergestellt (Reaktionsbedingungen: 1 h/227 °C, 1 h/248 °C, 3 h/283 °C). Das resultierende Polymere weist eine reduzierte Viskosität von 0,50 dl/g und einen OH-Gruppen-Gehalt von 12 µval/g auf.
Analog zu Beispiel 3 wird aus 95 Gewichtsteilen dieses Polyethersulfons und 5 Gewichtsteilen eines Bisphenol-A-diglycidylethers mit einem Epoxidgehalt von 5,26-5,38 val/kg ein Laminat hergestellt, dessen Eigenschaftswerte in Tabelle 2 angegeben sind.

Tabelle 2:

| Beispiel | 3 | 4 |
|---|---|---|
| Kupferhaftung (N/cm) | | |
| bei Raumtemperatur | 20,8 | 11,6 |
| bei 150 °C | 12,8 | |
| Flex-life (Zyklen) (Mittelwert aus 4 Messungen) | 274 | 284 |
| Materialdicke (µm) | 75 | 75 |

**Patentansprüche**

1. Zusammensetzungen enthaltend
   a) 2-40 Gew.% eines mehrfunktionellen Epoxids mit mindestens zwei direkt an ein Sauerstoff-, Stickstoff- oder Schwefelatom gebundenen Glycidylgruppen und
   b) 98-60 Gew.% eines vorwiegend OH-terminierten Homo- oder Copolymers mit einem Hydroxylgruppengehalt von mindestens 10 µval/g, welches 1-100 mol% eines wiederkehrenden Strukturelements der Formel (I)

$$-\!\left[ O-Ar_2-O-Ar_1 \right]\!- \quad (I)$$

und 99-0 mol% eines wiederkehrenden Strukturelements der Formel (II)

$$-\!\left[ O-Ar_3-O-Ar_1 \right]\!- \quad (II),$$

enthält,
worin $Ar_1$ einen zweiwertigen aromatischen Rest der Formeln (IIIa) - (IIIe) darstellt

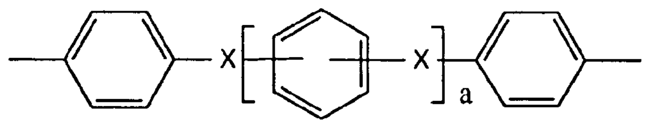 (IIIa),

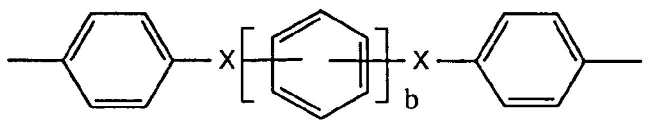 (IIIb),

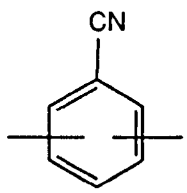 (IIIc), 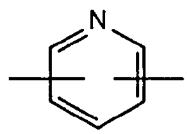 (IIId), 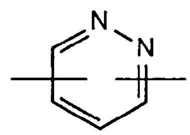 (IIIe),

worin X für -CO-, -SO- oder $-SO_2-$ steht, a die Zahl 0, 1 oder 2 bedeutet und b die Zahl 2 oder 3 ist, $Ar_2$ einen zweiwertigen aromatischen Rest der Formeln (IVa) bis (IVp) bedeutet

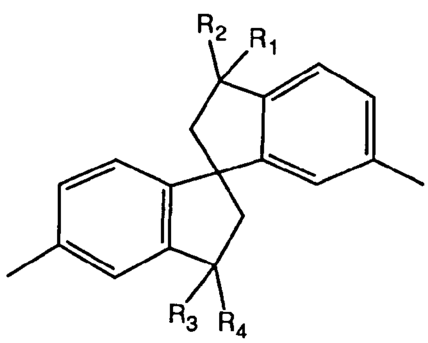 (IVa),

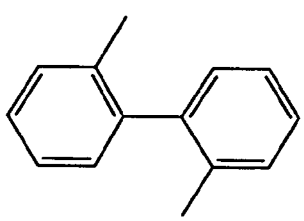 (IVb), 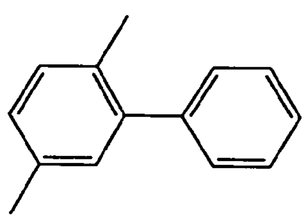 (IVc),

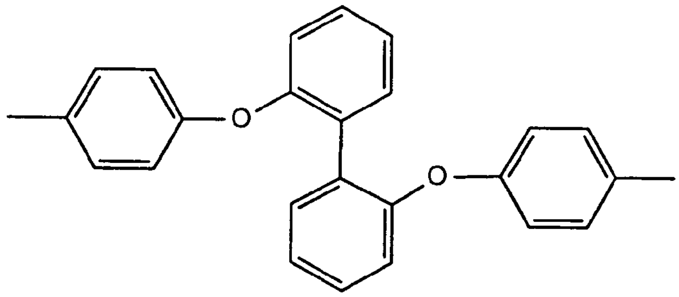

(IVd),

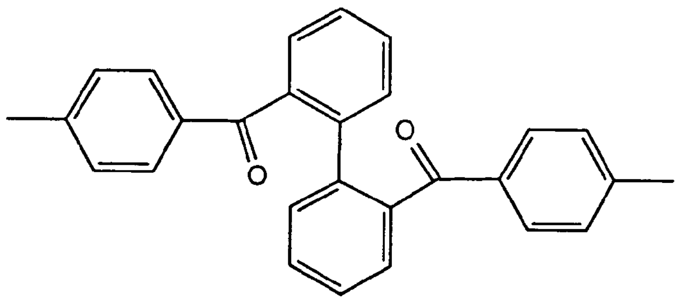

(IVe),

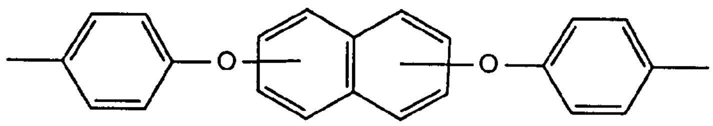

(IVf),

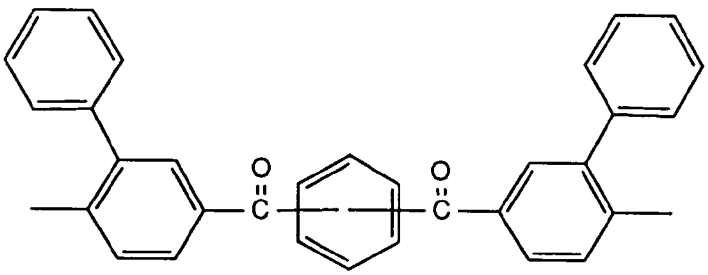

(IVg),

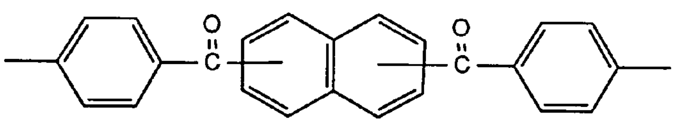

(IVh),

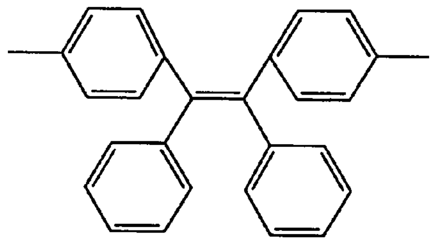 (IVi), 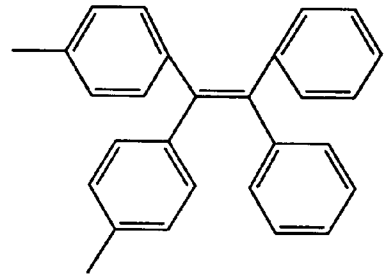 (IVj),

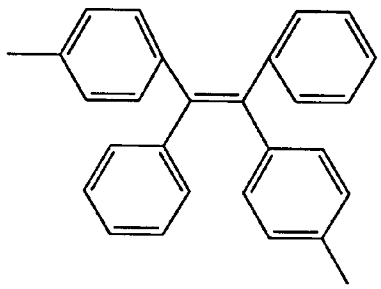 (IVk), 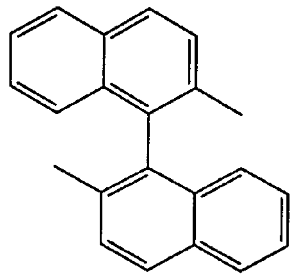 (IVl),

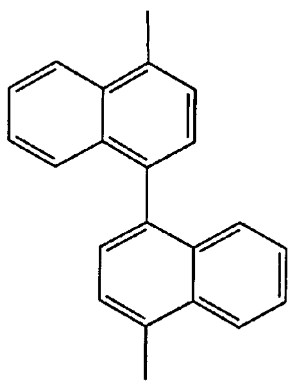 (IVm), 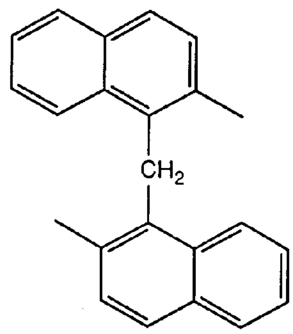 (IVn),

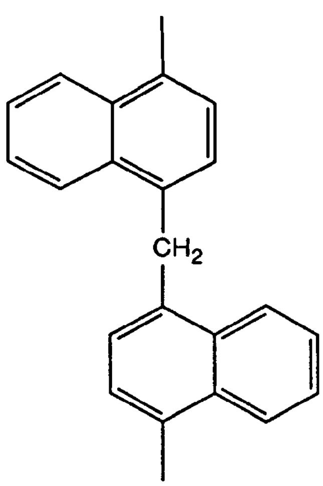 (IVo), 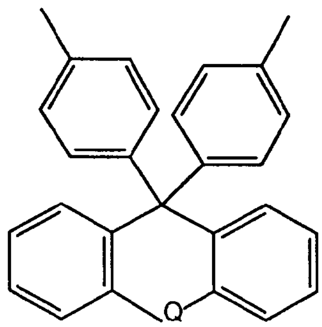 (IVp),

worin Q für eine direkte Bindung, $-CH_2-$, -O- oder -CO- steht,
$Ar_3$ einen zweiwertigen aromatischen Rest der Formeln (Va) bis (Vf) bedeutet

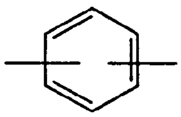 (Va), 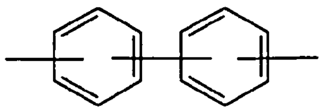 (Vb), 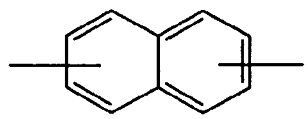 (Vc),

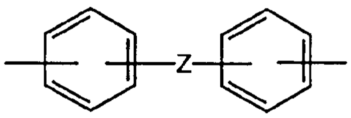 (Vd), 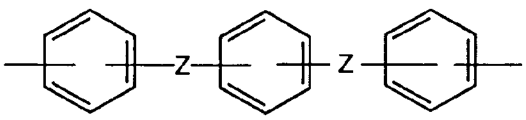 (Ve),

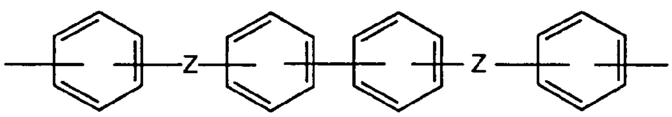 (Vf),

worin Z für $-CH_2-$, $-C(CH_3)_2-$, $-C(CH_3)(C_6H_5)-$, $-C(CF_3)_2-$, -S-, -O-, -SO-, $-SO_2-$ oder -CO- steht, worin die aromatischen Ringe der Formeln (IIIa)-(IIIe) unsubstituiert oder durch eine oder mehrere ($C_1$-$C_4$)-Alkylgruppen oder ($C_1$-$C_4$)-Alkoxygruppen substituiert sind und worin die aromatischen Ringe der Formeln (IVa)-(IVp) und (Va)-(Vf) unsubstituiert oder durch eine oder mehrere ($C_1$-$C_4$)-Alkylgruppen, ($C_1$-$C_4$)-Alkoxygruppen und/oder Halogenatome substituiert sind,
wobei die Menge des Epoxids a) so gewählt wird, dass pro Hydroxylgruppenäquivalent der komponente b) 2-15 Epoxidäquivalente der komponente a) eingesetzt werden.

**2.** Zusammensetzungen gemäss Anspruch 1, worin in den Formeln (I) und (II) $Ar_1$ für

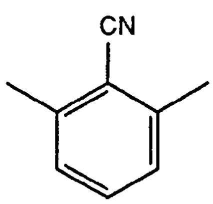 , 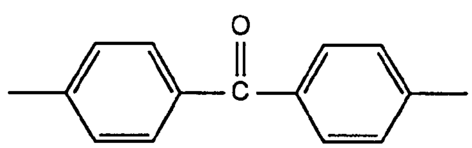

oder

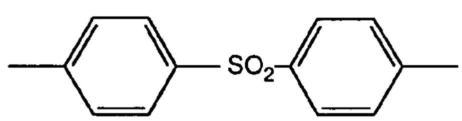

steht.

**3.** Zusammensetzungen gemäss Anspruch 1, worin in der Formel (I) $Ar_2$ für

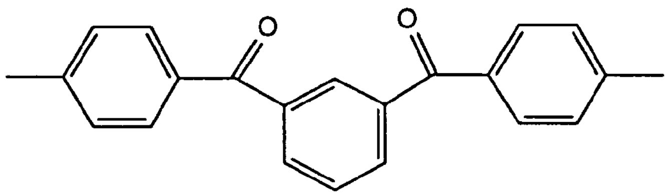,
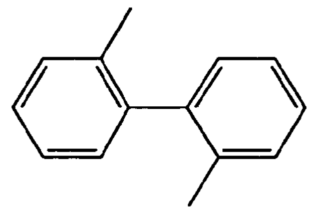

oder

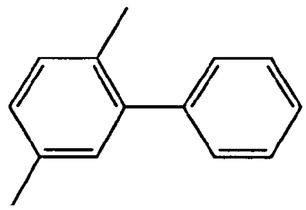

steht.

4. Zusammensetzungen gemäss Anspruch 1, worin in der Formel (II) $Ar_3$ für einen Rest der Formeln

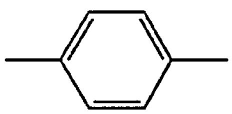,
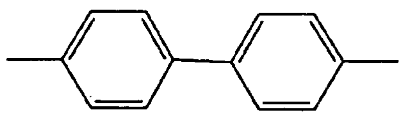,
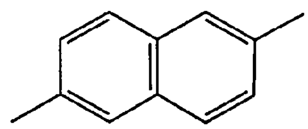,

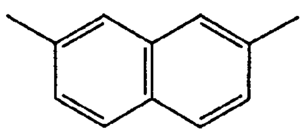,
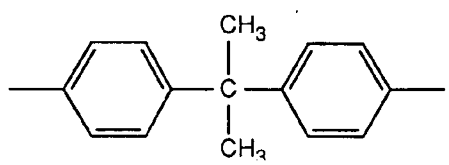,

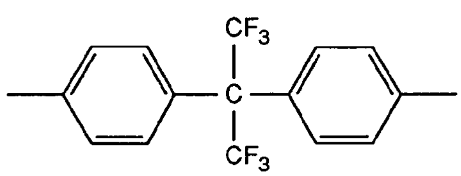,
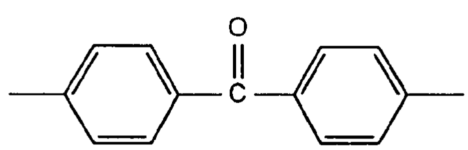

oder

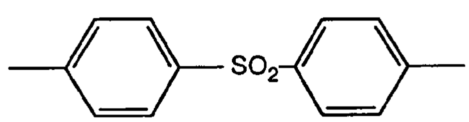;

steht.

5. Zusammensetzungen gemäss Anspruch 1, worin $Ar_1$ und $Ar_3$ für

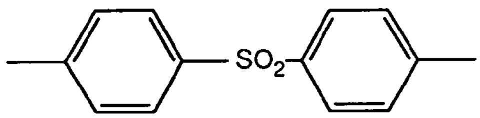 und $Ar_2$ für 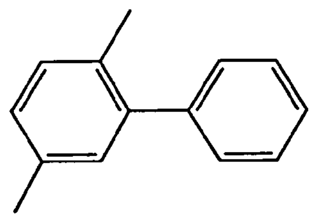

stehen.

**6.** Zusammensetzungen gemäss Anspruch 1, worin die aromatischen Ringe der Strukturelemente (IIIa)-(IIIe), (IVa)-(IVp) und (Va)-(Vf) unsubstituiert sind.

**7.** Zusammensetzungen gemäss Anspruch 1, worin das Epoxid ausgewählt wird aus der Gruppe bestehend aus Bisphenol-A-diglycidylether, Bisphenol-F-diglycidylether, Bisphenol-S-diglycidylether, Resorcindiglycidylether, N,N,O-Triglycidyl-p-aminophenol, N,N,O-Triglycidyl-m-aminophenol, Triglycidylisocyanurat, Tetraglycidyl-4,4'-diaminodiphenylmethan und Tetra(p-glycidyloxyphenyl)ethan.

**8.** Zusammensetzungen gemäss Anspruch 1, worin das Epoxid Bisphenol-A-diglycidylether ist.

**9.** Zusammensetzungen gemäss Anspruch 1 enthaltend 4-20 Gew.%, bevorzugt 5-15 Gew.%, der komponente a) und 96-80 Gew.%, bevorzugt 95-15 Gew.%, der komponente b).

**10.** Zusammensetzungen gemäss Anspruch 1 enthaltend als komponente b) ein Copolymer, welches 5-50 mol%, bevorzugt 5-25 mol%, eines wiederkehrenden Strukturelements der Formel (I) und 95-50 mol%, bevorzugt 95-75 mol%, eines wiederkehrenden Strukturelements der Formel (II) enthält,

**11.** Zusammensetzungen gemäss Anspruch 1, worin der Polyarylenether b) einen Hydroxylgruppengehalt von mindestens 20 µval/g aufweist.

**12.** Lösungen enthaltend etwa 1-75 Gew.%, bezogen auf die gesamte lösung, einer in einem organischen Lösungsmittel gelösten Zusammensetzung gemäss Anspruch 1.

**13.** Filme enthaltend eine Zusammensetzung gemäss Anspruch 1.

**14.** Laminate enthaltend mindestens eine Metallfolie und mindestens eine darauf direkt aufgebrachte Kunststoffschicht aus einer Zusammensetzung gemäss Anspruch 1.

**15.** Laminate gemäss Anspruch 14, worin die Metallfolie eine Kupferfolie ist.

**16.** Verfahren zur Herstellung von Laminaten gemäss Anspruch 14, dadurch gekennzeichnet, dass man eine mit einer Zusammensetzung gemäss Anspruch 1 beschichtete Metallfolie mit einer unbeschichteten Metallfolie oder mit einer oder mehreren mit einer Zusammensetzung gemäss Anspruch 1 beschichteten Metallfolie unter Druck zwischen 160 °C und 300 °C verpresst.